# EUROPÄISCHE PATENTANMELDUNG

(11) **EP 0 704 343 A2**
(43) Veröffentlichungstag der Anmeldung: **03.04.1996**
(21) Anmeldenummer: 95111923.9
(22) Anmeldetag: 28.07.1995
(51) Int. Cl.: B60R 16/02, G01R 31/00

(54) **Elektronisches Steuergerät in Kraftfahrzeugen**

(30) Priorität: 01.10.1994 DE 4435298
(71) Anmelder: Bayerische Motoren Werke Aktiengesellschaft, D-80788 München (DE)
(72) Erfinder: Froeschl, Joachim, D-82211 Herrsching (DE)

(57) **Zusammenfassung**

Bei einem elektronischen Steuergerät in Kraftfahrzeugen mit einer Steuereinheit zur vorzugsweise kombinierten Durchführung von Kraftfahrzeugfunktionen und Fehlerüberprüfungsroutinen im Normalbetrieb ist die Steuereinheit in einem vom Normalbetrieb unabhängigen Prüfbetrieb zur ausschließlichen Durchführung von Fehlerüberprüfungsroutinen einsetzbar.

## Beschreibung

Die Erfindung bezieht sich auf ein elektronisches Steuergerät in Kraftfahrzeugen mit einer Steuereinheit zur Durchführung von Kraftfahrzeugfunktionen im Normalbetrieb.

Ein derartiges elektronisches Steuergerät in Kraftfahrzeugen ist beispielsweise aus der DE 41 25 302 A1 bekannt. Dieses bekannte Steuergerät weist eine Steuereinheit auf, die in Abhängigkeit von erfaßten Betriebsgrößen des Kraftfahrzeugs durch Erzeugung von Ansteuersignalen für Aktuatoren verschiedene Kraftfahrzeugfunktionen, z. B. im Zusammenhang mit einem Antriebsschlupfregelungssystem, veranlaßt. Gleichzeitig werden Fehlerüberprüfungsroutinen durchgeführt. In der DE 41 25 302 A1 ist ein Beispiel für derartige Fehlerüberprüfungsroutinen beschrieben. Derartige Fehlerüberprüfungsroutinen werden kombiniert mit der Veranlassung von Kraftfahrzeugfunktionen durchgeführt, wodurch die Fehlerüberprüfungsroutinen beispielsweise nur innerhalb zulässiger Bedingungen durchführbar sind.

Bei Steuersystemen in Kraftfahrzeugen ist es allgemein üblich, zur Funktionsdurchführung auch eine Eigendiagnose des Steuergerätes und eine Funktionsüberwachung der Peripherie durchzuführen. Durch die Kombination der Durchführung von Kraftfahrzeugfunktionen und Fehlerüberprüfungsroutinen ist es erforderlich, daß an den Eingängen des Steuergeräts die im Normalbetrieb zu erwartenden Signale anliegen und an den Ausgängen die im Normalbetrieb zu aktivierenden Aktuatoren angeschlossen sind, die die ihnen zugeordneten Funktionen durchführen. Bei Fehlerüberprüfungsroutinen im Normalbetrieb werden beispielsweise meßtechnische oder plausibilitätsüberprüfende Maßnahmen ergriffen.

Bei derartigen elektronischen Steuergeräten mit einer Steuereinheit zur kombinierten Durchführung von Kraftfahrzeugfunktionen und Fehlerüberprüfungsroutinen ist daher zur Fehlerüberprüfung, insbesondere außerhalb des Kraftfahrzeugs, ein aufwendiger und kostenintensiver Testaufbau mit einer Simulation der realen Steuergeräteperipherie notwendig. Es ist daher Aufgabe der Erfindung, ein elektronisches Steuergerät eingangs genannter Art derart zu verbessern, daß ein einfacher und einheitlicher Testaufbau ausreicht, um insbesondere außerhalb des Kraftfahrzeugs, z. B. bei Entwicklungstätigkeiten oder bei Recyclingprüfungen, die Hardware des elektronischen Steuergeräts auf ihre Funktionstüchtigkeit bzw. Fehler hin überprüfen zu können.

Diese Aufgabe wird durch die kennzeichnenden Merkmale des Anspruchs 1 gelöst.

Erfindungsgemäß ist das elektronische Steuergerät bzw. die Steuereinheit eines elektronischen Steuergeräts für Kraftfahrzeuge in einem vom Normalbetrieb unabhängigen Prüfbetrieb zur ausschließlichen Durchführung von Fehlerüberprüfungsroutinen einsetzbar.

Vorzugsweise enthält das Steuergerät einen Mikroprozessor und eine Steuereinheit in Form eines Programmspeichers. Die Steuereinheit kann jedoch auch durch die Kombination eines Programmspeichers und eines Mikroprozessors definiert sein. Der Prüfbetrieb kann z.B. durch ein entsprechendes Programm ausgeführt werden, das löschbar bzw. überschreibbar in der Steuereinheit vorliegt. Dieses Programm kann allein in der Steuereinheit einprogrammiert sein, wenn eine Durchführung der dem Steuergerät zugeordneten Kraftfahrzeugfunktionen nicht angefordert wird.

Durch einen derartigen eigenständigen Prüfbetrieb ist es möglich, Fehlerüberprüfungsroutinen, insbesondere zur Fehlerüberprüfung der Hardware eines elektronischen Steuergeräts, einerseits mit vereinfachter Peripherie und andererseits mit erhöhter Prüftiefe, z.B. mit erhöhter Abtastrate, durchzuführen. Hierzu können beispielsweise anstelle der verschiedenen realen Eingangssignale des Steuergeräts ein einheitliches, vereinfachtes Testsignal verwendet, auf Plausibilitätsüberprüfungen verzichtet und reale Aktuatoren durch vereinfachte Lasten, wie ohmsche Widerstände, Induktivitäten oder Kapazitäten, ersetzt werden. Somit ist ein vereinfachter und kostengünstiger Testaufbau zur Überprüfung elektronischer Steuergeräte möglich, der zudem derart ausgebildet sein kann, daß mehrere Steuergeräteversionen mit nur einem Testaufbau auf Fehler überprüft werden können.

Eine vorteilhafte Weiterbildung der Erfindung ist der Gegenstand des Patentanspruchs 2.

Erfindungsgemäß weist die Steuereinheit eine eigenständige Prüfeinheit zur Durchführung des Prüfbetriebs bzw. zur ausschließlichen Durchführung von den vom Normalbetrieb unabhängigen Fehlerüberprüfungsroutinen auf. Im Programmspeicher des Steuergeräts sind z.B. ein erster Programmteil zur kombinierten Durchführung von Kraftfahrzeugfunktionen und Fehlerüberprüfungsroutinen im Normalbetrieb und ein zweiter Programmteil zur ausschließlichen Durchführung von den vom Normalbetrieb unabhängigen Fehlerüberprüfungsroutinen abgelegt. Die eigenständige Prüfeinheit wird insbesondere durch den zweiten Programmteil, der von dem ersten Programmteil unabhängig ist, im Zusammenwirken mit dem Mikroprozessor gebildet. Mit einer derartigen eigenständigen Prüfeinheit ist es möglich, Fehlerüberprüfungsroutinen auch dann durchzuführen, wenn die Steuereinheit vorrangig für den Normalbetrieb programmiert ist. Hierdurch wird die Flexibilität des Steuergeräteeinsatzes erhöht.

Eine vorteilhafte Weiterbildung der Erfindung ist der Gegenstand des Patentanspruchs 3.
Erfindungsgemäß ist die eigenständige Prüfeinheit in einem unabhängigen Prüfbetrieb abweichend vom Normalbetrieb willkürlich aktivierbar.
Beispielsweise könnte der Prüfbetrieb durch einen manuell eingebbaren Prüfcode an einem bestimmten Eingang des Steuergerätes aktiviert werden. Hierdurch ist sichergestellt, daß die Prüfeinheit zur ausschließlichen Durchführung von Fehlerüberprüfungsroutinen nicht während des Kraftfahrzeugbetriebs aktiviert werden kann, so daß eine Fehlfunktion der Steuereinheit vermieden wird.

Eine weitere vorteilhafte Ausgestaltung der Erfindung ist der Gegenstand des Patentanspruchs 4.
Erfindungsgemäß ist die Prüfeinheit durch ein Signal automatisch aktivierbar, das an mindestens einem Eingang des Steuergerätes anliegt und das sich von dem diesem Eingang im Normalbetrieb Zugeordneten Signal unterscheidet.
Mit dieser erfindungsgemäßen Weiterbildung wird zum einen verhindert, daß die Prüfeinheit ungewollt aktiviert wird und zum anderen ermöglicht, daß die Prüfeinheit ohne Zusatzgerät automatisch aktivierbar ist.

In der Zeichnung ist ein Ausführungsbeispiel der Erfindung dargestellt. Es zeigt
- Fig. 1: ein elektronisches Steuergerät nach dem Stand der Technik mit einer Steuereinheit ausschließlich zur kombinierten Durchführung von Kraftfahrzeugfunktionen und Fehlerüberprüfungsroutinen und
- Fig. 2: eine erfindungsgemäße Steuereinheit mit einer eigenständigen Prüfeinheit.

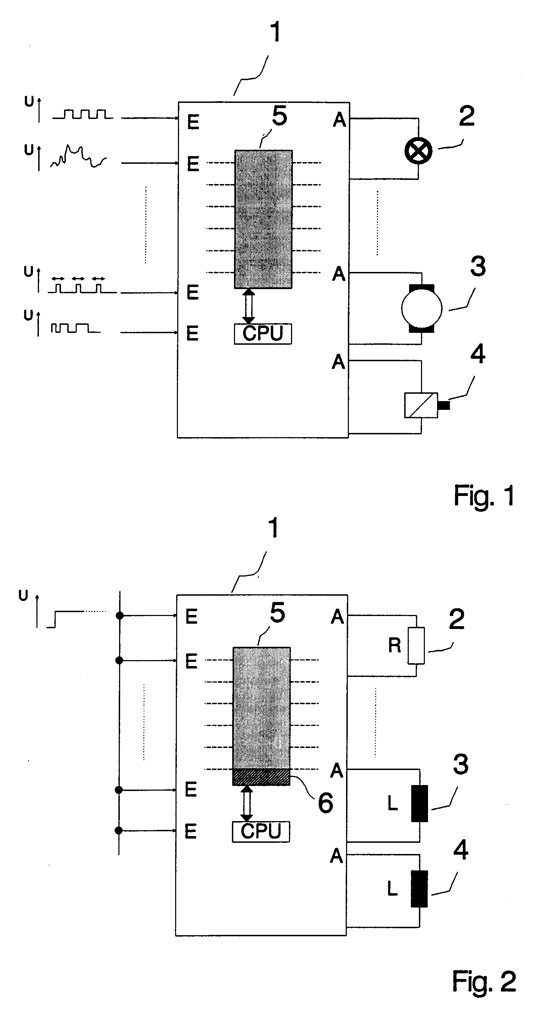

In Fig. 1 ist ein elektronisches Steuergerät 1 mit verschiedenen Aktuatoren 2, 3 und 4 dargestellt. Die Aktuatoren 2, 3 und 4 können beispielsweise eine Lampe 2, ein Elektromotor 3 und ein elektrisches Magnetventil 4 sein. Das Steuergerät 1 weist eine Steuereinheit 5 in Form eines mit einem Mikroprozessor CPU zusammenwirkenden Programmspeichers zur kombinierten Durchführung von Kraftfahrzeugfunktionen und Fehlerüberprüfungsroutinen im Normalbetrieb auf. Die Durchführung der Kraftfahrzeugfunktionen wird in Abhängigkeit von verschiedenen Eingangssignalen an den Eingängen E des Steuergerätes 1 mittels der Ansteuersignale der Aktuatoren 2, 3 und 4 an den Ausgängen A des Steuergerätes 1 veranlaßt. Dabei prüft die Steuereinheit 5 beispielsweise, ob an den Eingängen E die erwarteten Eingangssignale tatsächlich anliegen. Die erwarteten Eingangssignale können verschiedenster Art sein, z. B. Impulssignale mit einer bestimmten Frequenz, Analogsignale, impulsweitenmodulierte Signale oder Impulse mit drehzahlabhängiger Periodendauer. Weiterhin werden bei den Fehlerüberprüfungsroutinen im Normalbetrieb auch Plausibilitätsüberwachungen bezüglich der anliegenden Eingangssignale vorgenommen.

Ein elektronisches Steuergerät mit einer derartigen Steuereinheit kann demnach nur dann getestet werden, wenn die zu erwartenden Eingangssignale plausibel anliegen und vorzugsweise auch die realen Aktuatoren 2, 3 und 4 angeschlossen sind.

In Fig. 2 ist ebenfalls ein elektronisches Steuergerät 1 mit einer Steuereinheit 5, Eingängen E und Ausgängen A dargestellt. Die Steuereinheit 5 weist eine Prüfeinheit 6 auf, die entweder Teil der Steuereinheit oder eine Erweiterung der Steuereinheit sein kann. Anstelle der realen Aktuatoren 2, 3 und 4 sind vereinfachte, den realen Aktuatoren entsprechende Lasten dargestellt. Anstelle der Lampe 2 ist ein ohmscher Widerstand R, anstelle des Elektromotors eine Induktivität L und anstelle des elektrischen Magnetventils 4 eine Induktivität L angeschlossen. Zur Überprüfung der Hardware des elektronischen Steuergeräts 1 reichen derartige Ersatzlasten aus, um die Funktionsfähigkeit zur Ausgabe der Ausgangssignale überprüfen zu können. Anstelle der realen Eingangssignale wird ein Prüfsignal U an jeden Eingang E des Steuergeräts 1 angelegt. Mit geeigneter Software in der Prüfeinheit 6 ist für eine Fehlerüberprüfung der Hardware ein derartiges Prüfsignal ausreichend, um beispielsweise die Beschaltung der Eingänge des Steuergeräts 1 bis zur Erfassung des Eingangssignals durch die Steuereinheit 5 zu überprüfen. Da die Prüfeinheit 6 unabhängig vom Normalbetrieb arbeitet, ist eine Fehlerüberprüfung des Steuergeräts 1 unabhängig von dem Programmteil zur Durchführung der Kraftfahrzeugfunktionen möglich, wodurch ein derart vereinfachter und für mehrere Steuergeräteversionen verwendbarer Testaufbau nach Fig. 2 ausreicht. Vorzugsweise wird der Prüfbetrieb bzw. die Prüfeinheit 6 automatisch dann aktiviert, wenn an den Eingängen E des Steuergerätes 1 anstelle der realen Eingangssignale das in Fig. 2 dargestellte Prüfsignal anliegt.

Ergänzend sei darauf hingewiesen, daß die Steuereinheit 5 bei entsprechender Programmierung auch ohne eigenständiger Prüfeinheit in einem Prüfbetrieb arbeiten kann. Beispielsweise kann bei Entwicklungtätigkeiten oder Recyclingtests auf einen Programmteil zur Durchführung der Kraftfahrzeugfunktionen verzichtet werden, wodurch in der Steuereinheit lediglich ein vom Normalbetrieb abweichendes Programm zur Durchführung des Prüfbetriebs vorliegen kann, das bei Bedarf wieder umprogrammierbar ist.

## Patentansprüche

1. Elektronisches Steuergerät in Kraftfahrzeugen mit einer Steuereinheit zur Durchführung von Kraftfahrzeugfunktionen im Normalbetrieb, dadurch gekennzeichnet, daß die Steuereinheit (5) in einem vom Normalbetrieb unabhängigen Prüfbetrieb zur ausschließlichen Durchführung von Fehlerüberprüfungsroutinen einsetzbar ist.

2. Steuergerät nach Patentanspruch 1, dadurch gekennzeichnet, daß die Steuereinheit (5) eine eigenständige Prüfeinheit (6) zur Durchführung des Prüfbetriebs aufweist.

3. Steuergerät nach Patentanspruch 1 oder 2, dadurch gekennzeichnet, daß der Prüfbetrieb willkürlich aktivierbar ist.

4. Steuergerät nach einem der Patentansprüche 1 bis 3, dadurch gekennzeichnet, daß der Prüfbetrieb durch ein Signal aktivierbar ist, das an einem Eingang (E) des Steuergeräts (1) anliegt und das sich von dem diesem Eingang (E) im Normalbetrieb zugeordneten Signal unterscheidet.
